# EUROPÄISCHE PATENTSCHRIFT

(11) **EP 1 287 566 B1**
(45) Veröffentlichungstag und Bekanntmachung des Hinweises auf die Patenterteilung: **22.10.2003**
(21) Anmeldenummer: 01923379.0
(22) Anmeldetag: 25.04.2001
(51) Int. Cl.: H01L 35/08, H01L 35/32, H01L 35/26

(54) **THERMOELEKTRISCHES ELEMENT**
THERMOELECTRIC ELEMENT
ELEMENT THERMOELECTRIQUE

(30) Priorität: 02.05.2000 AT 7632000
(43) Veröffentlichungstag der Anmeldung: 05.03.2003
(73) Patentinhaber: Span, Gerhard, 6112 Wattens (AT)
(72) Erfinder: Span, Gerhard, 6112 Wattens (AT)
(74) Vertreter: Hofinger, Engelbert, Dr.Dr.
(86) Internationale Anmeldenummer: AT0100123
(87) Internationale Veröffentlichungsnummer: WO01084641

(56) Entgegenhaltungen:
- EP-A- 0 124 128
- EP-A- 0 369 670
- GB-A- 2 283 361
- US-A- 2 981 775
- US-A- 3 564 860
- US-A- 4 850 713
- US-A- 5 376 184
- US-A- 5 644 184
- PATENT ABSTRACTS OF JAPAN vol. 013, no. 513 (E-847), 16. November 1989 (1989-11-16) & JP 01 208876 A (MATSUSHITA ELECTRIC IND CO LTD), 22. August 1989 (1989-08-22)

## Beschreibung

Die Erfindung betrifft ein Thermoelektrisches Element mit mindestens einer n-Schicht und mindestens einer p-Schicht eines oder mehrerer dotierter Halbleiter, wobei die n-Schicht(en) und die p-Schicht(en) unter Ausbildung wenigstens eines pn-Überganges angeordnet sind, wobei zumindest eine n-Schicht und zumindest eine p-Schicht elektrisch selektiv kontaktiert sind und ein Temperaturgradient parallel (x-Richtung) zur Grenzschicht zwischen wenigstens einer n- und p-Schicht angelegt oder abgegriffen wird.

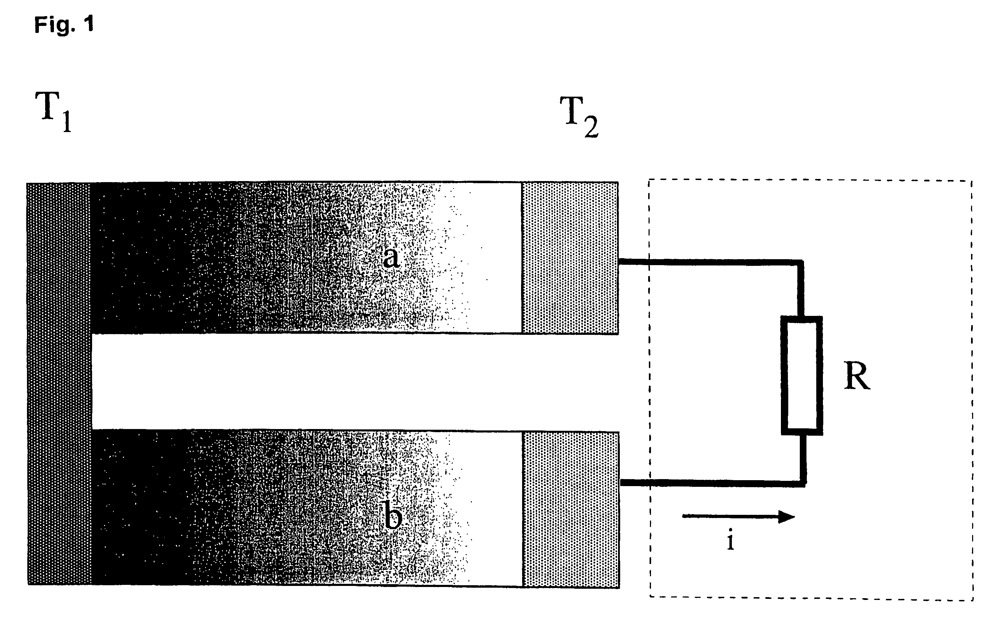

Der thermoelektrische Effekt ist bereits seit mehr als 100 Jahren bekannt. Es gibt ein breites Spektrum an Materialien, die für die direkte Umwandlung eines Temperaturgradienten in elektrischen Strom verwendet werden können. Die technische Umsetzung dieses Effektes basiert bisher immer auf einen gemeinsamen grundsätzlichen Aufbau (Fig. 1). Zwei unterschiedliche Metalle (a, b) oder zwei unterschiedlich (n- und p-) dotierte Halbleiter werden an einem, im Normalfall dem heißen Ende (Temperatur T₁) verbunden, und am anderen, normalerweise kalten Ende (Temperatur T₂) kann dann der Strom abgegriffen werden (Widerstand R als symbolischer Verbraucher). Solche thermoelektrischen Elemente sind zB aus den Schriften EP 0 969 526 A1, JP 11195817 A, JP 10144969 A, JP 10022531 A, JP 10022530 A, JP 57-1276 (A), JP 07038158 A, JP 59-980 (A), JP 57-169283 (A), JP 4-63481 (A) und US 5,009,717 bekannt, wobei teilweise eine leitende Schicht als Kontaktfläche zwischen n- und p-Schicht im Bereich des p-n Übergangs eingebaut ist. Allen diesen Thermoelektrischen Element ist gemeinsam, daß der p-n Übergang nur in einem kleinen Bereich zwischen der n- und der p-Schicht ausgebildet ist, während der größere Bereich zwischen n- und p-Schicht als Luftspalt oder als isolierende Schicht (JP-63481 (A) und US 5,009,717) ausgebildet ist.

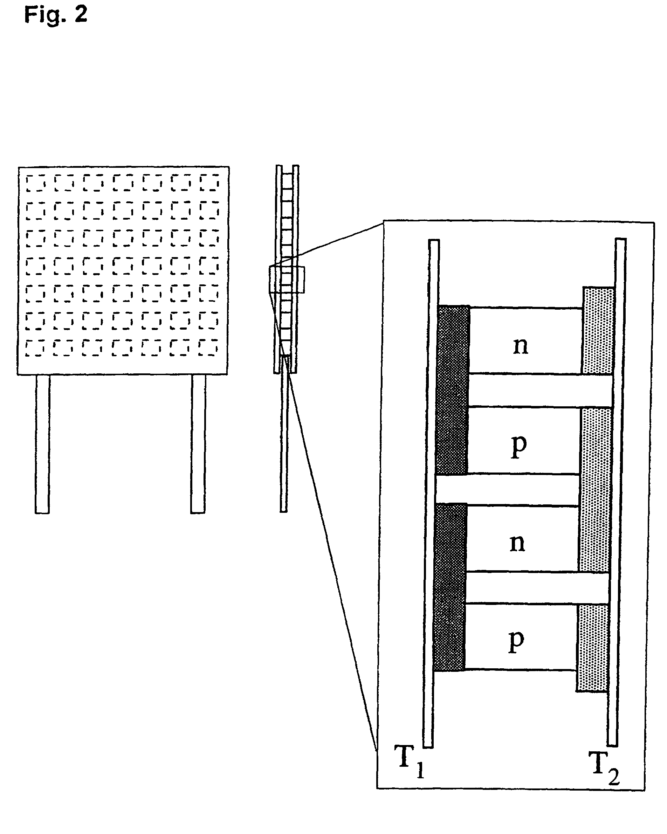

Um eine möglichst effektive Umwandlung des Temperaturgradienten in elektrischen Strom zu erhalten, werden die thermoelektrischen Elemente so zu einem Modul zusammen gebaut, daß die einzelnen Elemente elektrisch in Serie, aber thermisch parallel geschaltet sind. Diese Module lassen sich wiederum zu größeren Einheiten zusammenfassen (Fig. 2).

Die Auswahl der verwendeten Materialien erfolgt nach dem Gesichtspunkt des maximal möglichen Wirkungsgrades im angestrebten Temperaturbereich. Der Wirkungsgrad wird im allgemeinen durch die figure of merit Z = S²/ρk charakterisiert (S ... Seebeck-Koeffizient oder absolute differentielle Thermokraft, ρ ... spezifischer Widerstand, k ... Wärmeleitfähigkeit) angegeben. Ein hoher Wirkungsgrad wird in einem Material mit hohem Seebeck-Koeffizient bei gleichzeitigem niedrigem spezifischem Widerstand und niedriger Wärmeleitfähigkeit erreicht.

Der Stand der Technik weist einige Nachteile auf: Die für die Thermoelektrizität wichtigen Eigenschaften eines Materials (S ... Seebeck-Koeffizient, ρ ... spezifischer Widerstand, k ... Wärmeleitfähigkeit) lassen sich nur in sehr geringem Maße voneinander unabhängig beeinflussen. Dieser Zusammenhang begrenzt die derzeit realisierbaren Wirkungsgrade auf ca. 10-20%.

Der Verlauf des Temperaturgradienten hat beim Stand der Technik kaum einen Einfluß auf den Wirkungsgrad, da in konventionellen thermoelektrischen Elementen aufgrund des linearen Zusammenhangs zwischen Thermokraft und Temperaturdifferenz nur die Gesamtdifferenz der Temperatur zwischen heißer und kalter Seite eine Rolle spielt.

Die Versuche, alternative Konzepte wie z.B. Dioden (pn-Übergänge) so zu verwenden, daß eine Seite des pn-Übergangs wärmer als die andere Seite ist, zeigen zwar eine Steigerung des Wirkungsgrades, das ursprüngliche Konzept wurde aber nicht wesentlich erweitert.

Aufgabe der Erfindung ist es daher, ein verbessertes thermoelektrisches Element zu schaffen.

Dies wird erfindungsgemäß dadurch erreicht, daß mindestens ein pn-Übergang im wesentlichen entlang der gesamten vorzugsweise längsten Ausdehnung der n-Schicht(en) und der p-Schicht(en) und damit im wesentlichen entlang deren gesamter Grenzschicht ausgebildet ist.

Eine zentrale, grundlegend neue Idee ist es, mindestens einen pn-Übergang zu verwenden, wobei der Temperaturgradient entlang des eine entsprechende Längserstreckung aufweisenden pn-Überganges verläuft.

Beim Stand der Technik ist der pn-Übergang nur in einem kleinen Kontaktbereich mit konstanter Temperatur meist auf der Hochtemperaturseite des thermoelektrischen Elementes ausgebildet. Er dient damit nur zur Verbesserung des elektrischen Kontaktes zwischen den n- und dem p-dotierten Teilen (Schichten). Im Gegensatz hierzu ist erfindungsgemäß konstruktiv vorgesehen, daß mindestens ein pn-Übergang im wesentlichen über die gesamte Erstreckung der n-und p-Schichten ausgebildet ist, wobei ein Temperaturgradient entlang der pn-Übergangsgrenzfläche angelegt wird. Hierdurch entsteht ein Temperaturunterschied entlang dieses länglich ausgebildeten pn-Übergangs zwischen zwei Enden eines p-n-Schichtpaketes, welcher dazu führt, daß der Wirkungsgrad des erfindungsgemäßen thermoelektrischen Elementes deutlich höher ist als beim Stand der Technik, welcher keinen Temperaturgradienten entlang und innerhalb des p-n-Überganges aufweist. Die genauere Wirkungsweise beruht auf der verschiedenartigen Ausbildung von Potentialmodulationen in einem pn-Übergang bei verschiedenen Temperaturen, wie es im folgenden anhand der Figurenbeschreibung erläutert wird.

Wichtig für das Funktionsprinzip dieses neuartigen thermoelektrischen Elementes ist die selektive Kontaktierung von n- und p-Schicht. Dies kann vorzugsweise entweder durch Einlegieren der Kontakte und den damit verbundenen pn-Übergängen oder durch eine direkte Kontaktierung der einzelnen Schichten geschehen.

Weitere Vorteile und Einzelheiten der Erfindung werden an Hand der nachfolgenden Figurenbeschreibung näher erläutert: Es zeigen:
- Die Fig. 1: eine Prinzipskizze eines Thermoelementes nach dem Stand der Technik,
- die Fig. 2: einen thermoelektrischen Modul nach dem Stand der Technik,
- die Fig. 3: die Prinzipskizze eines Ausführungsbeispiels eines erfindungsgemäßen thermoelektrischen Elementes,
- die Fig. 3a und 3b: weitere Ausführungsbeispiele mit unterschiedlicher selektiver Kontaktierung der n-Schicht bzw. p-Schicht,
- die Fig. 4: das Potential v im Bereich des pn-Übergangs als Funktion der Ortskoordinate z senkrecht zum pn-Übergang,
- die Fig. 5: zwei Diagramme gemäß Fig. 4, jedoch bei verschiedenen Temperaturen T₁ und T₂,
- die Fig. 6: eine schematische dreidimensionale Darstellung zur Entstehung des Potentialgradienten in der n- und p-Schicht,
- die Fig. 7: eine schematische Darstellung zur Entstehung einer ambipolaren Diffusion,
- die Fig. 8: ein Diagramm zur Generation von Elektron-Loch-Paaren,
- die Fig. 9: die Rekombination von Elektron-Loch-Paaren durch Verkleinern der Potentialmodulation,
- die Fig. 10: einen günstigen Verlauf des Temperaturgradienten über das thermoelektrische Element,
- die Fig. 11: ein thermoelektrisches Element mit einer Breitenvariation in der Draufsicht sowie den damit erzielten Temperaturgradienten,
- die Fig. 12: ein Ausführungsbeispiel mit zwei pn-Übergängen,
- die Fig. 13: den Aufbau eines thermoelektrischen Moduls aus mehreren erfindungsgemäßen thermoelektrischen Elementen und
- die Fig. 14: ein Ausführungsbeispiel mit einer hochdotierten n-, einer n-, einer p- und einer hochdotierten p-Schicht.

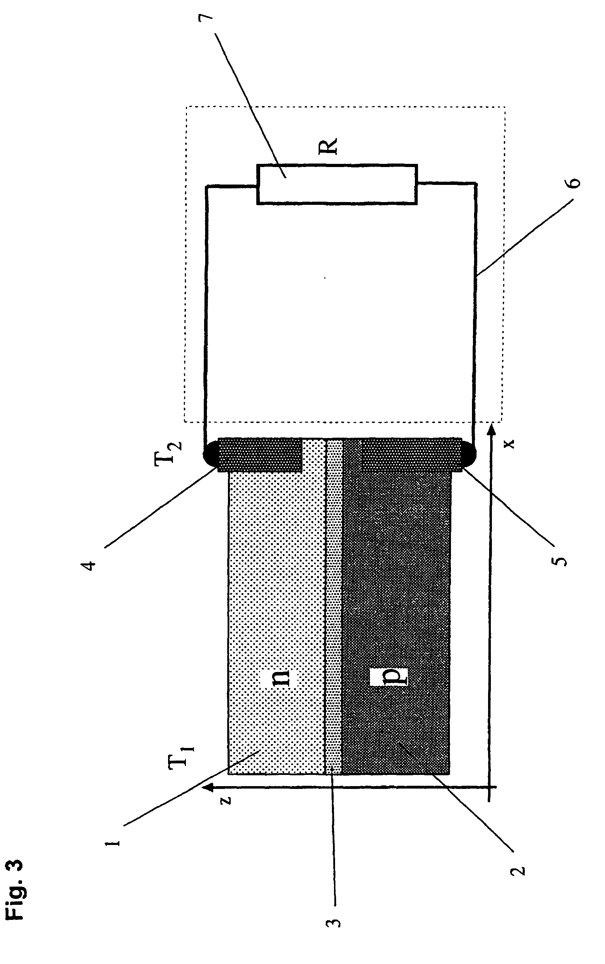

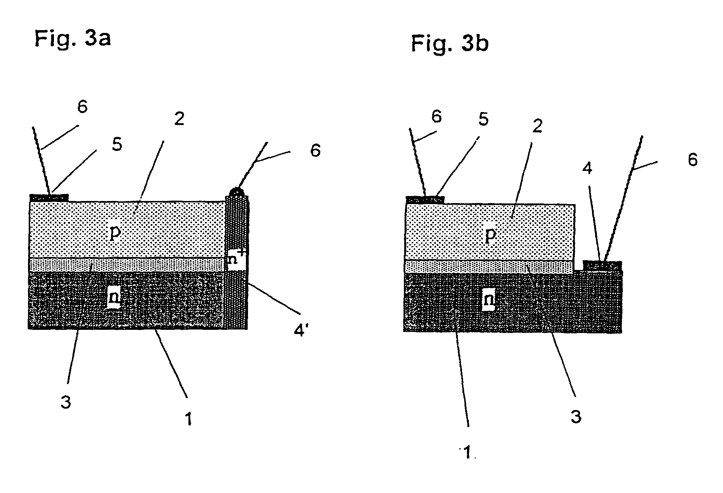

Der prinzipielle Aufbau eines erfindungsgemäßen thermoelektrischen Elementes ist in Fig. 3 gezeigt. Eine n-Schicht 1 und eine p-Schicht 2 bildet einen pn-Übergang 3 aus. Die n-Schicht 1 und die p-Schicht 2 sind über Kontakte 4 und 5 selektiv kontaktiert, welche über eine Leitung 6 zum ohmschen Verbraucher 7 (R) führen. Der Temperaturgradient (T₁ kennzeichnet die höhere Temperatur, T2 kennzeichnet die niedere Temperatur) wird in Richtung parallel zum pn-Übergang 3 (x-Richtung) angelegt.

Die Figuren 3a und 3b zeigen Ausführungsbeispiele zur selektiven Kontaktierung der n-Schicht 1 bzw. der p-Schicht 2. Die Schichtdicken sind dabei im Vergleich zur Ausdehnung des Kontaktes in x-Richtung deutlich größer dargestellt (etwa Faktor 100-1000). Bei dem in Fig. 3a dargestellten Ausführungsbeispiel wird die p-Schicht 2 direkt über einen oberflächlich aufgedampften Goldkontakt 5 kontaktiert (Golddraht 6). Zur Kontaktierung der n-Schicht wird ein einlegierter Kontakt 4' verwendet. Für PbTe kann beispielsweise Indium für den einlegierten Kontakt verwendet werden. Das Indium wird oberflächlich aufgebraucht und durch Erwärmen in das Schichtpaket eindiffundiert. Die Legierung PbTe-Indium ist vom Typ n⁺ (hochdotiert). Es bildet sich also ein ohmscher Kontakt zur n-Schicht 1 und ein pn-Übergang zur p-Schicht 2.

Bei dem in Fig. 3b dargestellten Ausführungsbeispiel erfolgt die Kontaktierung der n-Schicht 1 und der p-Schicht 2 direkt, beispielsweise ist dies durch selektives Abätzen der Deckschicht möglich.

Der besondere Clou der Lösung liegt darin, daß die nichtlinearen thermischen Eigenschaften von pn-Übergängen ausgenützt werden. Die Temperatur beeinflußt sowohl die Fermienergie als auch (und vor allem) die energetische Verteilung der Ladungsträger. In einem pn-Übergang folgt daraus eine Veränderung der Potentialmodulation. Die Potentialmodulation beschreibt hierbei eine Modulation des Potentials für Ladungsträger in Halbleiterstrukturen z.B. durch einen pn-Übergang. So befindet sich ein Elektron energetisch auf einem höheren Potential in der p-Schicht als in der n-Schicht (für Löcher ist es umgekehrt), wobei die Differenz dieser beiden Potentiale die Potentialmodulation ist. Da nun für jede Temperatur ein Gleichgewichtswert für die Potentialmodulation existiert, kommt es zur Veränderung der Potentialmodulation, wenn sich die Temperatur verändert.

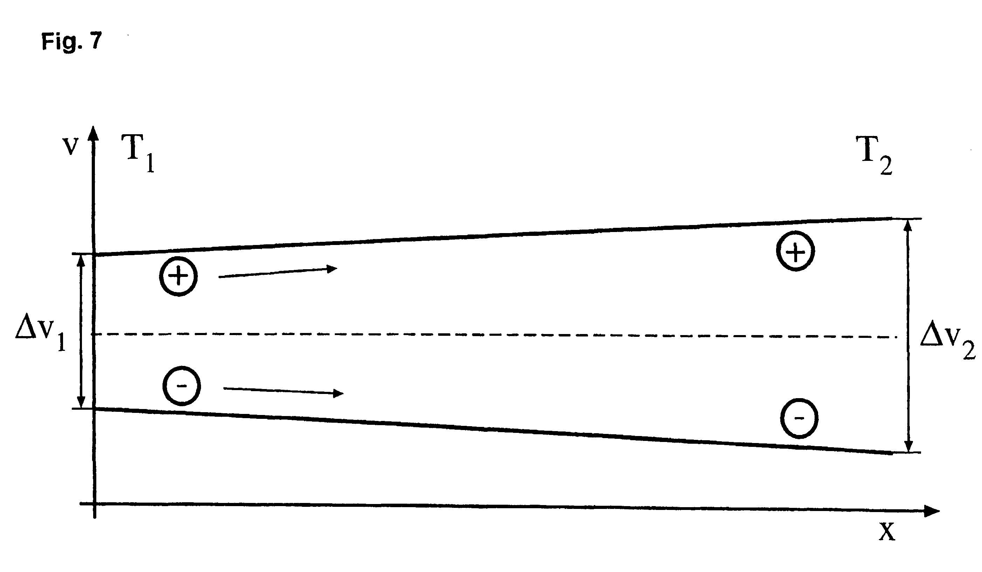

Durch einen Temperaturgradienten parallel zur Grenzschicht zwischen n- und p-Schicht kommt es daher zu einem Aufbau eines lateralen Potentialgradienten in x-Richtung, dadurch zu einer ambipolaren Ladungsträgerdiffusion und damit zu Ausgleichsströmen. Hierbei bezeichnet die ambipolare Ladungsträgerdiffusion die gleichgerichtete Diffusion ungleichnamiger Ladungsträger im gleichgerichteten Konzentrationsgefälle, wie es anhand von Fig. 7 beschrieben ist. Durch die selektiven Kontakte (separate, nicht miteinander in leitender Verbindung stehende Kontakte für n- und p-Schicht) kann dieser interne Ausgleichsstrom nach außen geführt werden. Dieser Vorgang wird in den folgenden Abschnitten kurz beschrieben werden.

Als Beispiel soll der Schmalbandhalbleiter PbTe (Bleitellurid) betrachtet werden: Die Änderung der Potentialmodulation und damit die maximale theoretisch nutzbare Spannung des thermoelektrischen Elementes liegt bei ca. 20mV/100K = 2x10⁻⁴V/K (Volt/Grad Kelvin) und damit höher als die Größenordnung des Seebeck Koeffizienten von ca. 1x10⁻⁶V/K. Durch Aufbau von Modulen aus in Serie geschalteten Elementen lassen sich höhere Spannungen erreichen.

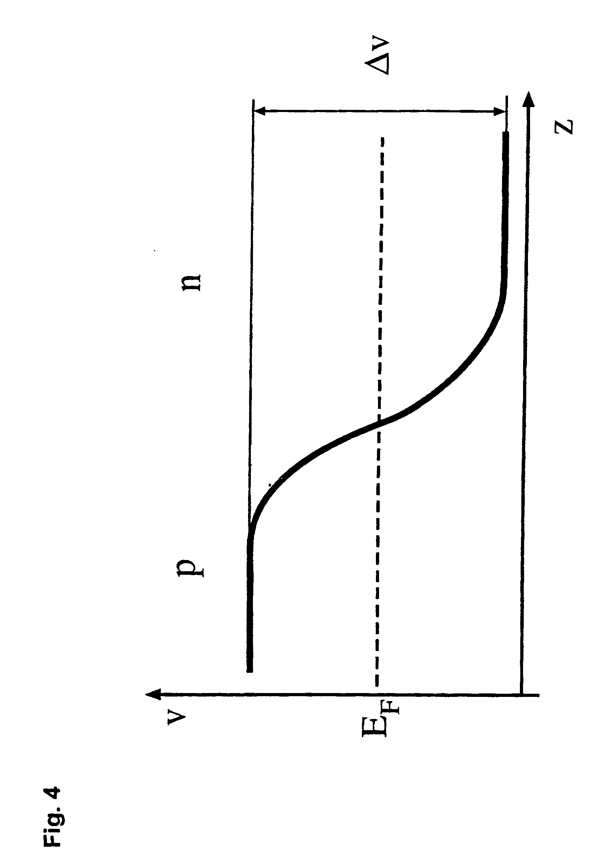

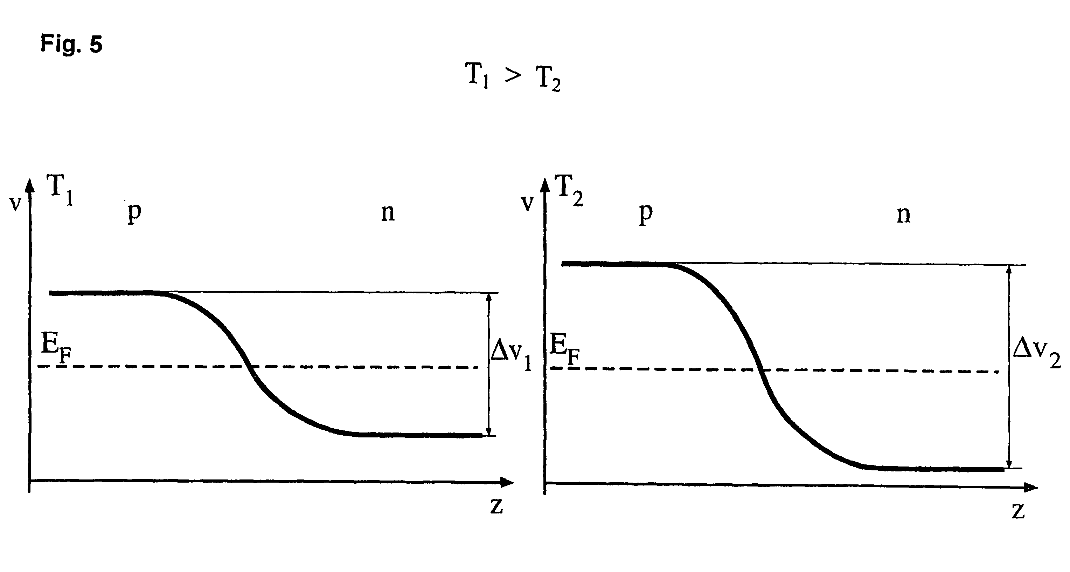

Im thermischen Gleichgewicht veteilen sich die Ladungsträger (n und p) so, daß sich eine gemeinsame Fermienergie E_{f} ausbildet (Fig. 4). Die Lage der Fermienergie ist eine Funktion der Temperatur und eine Potentialmodulation Δv stellt sich ein, die Potentialmodulation wird also auch zu einer Funktion der Temperatur. Für zwei verschiedene Temperaturen T₁ und T₂, wobei T₁ höher als T₂ ist, ergibt sich die Situation wie in Fig. 5 dargestellt. Der pn-Übergang mit der höheren Temperatur T1 hat eine geringere Potentialmodulation Δv₁.

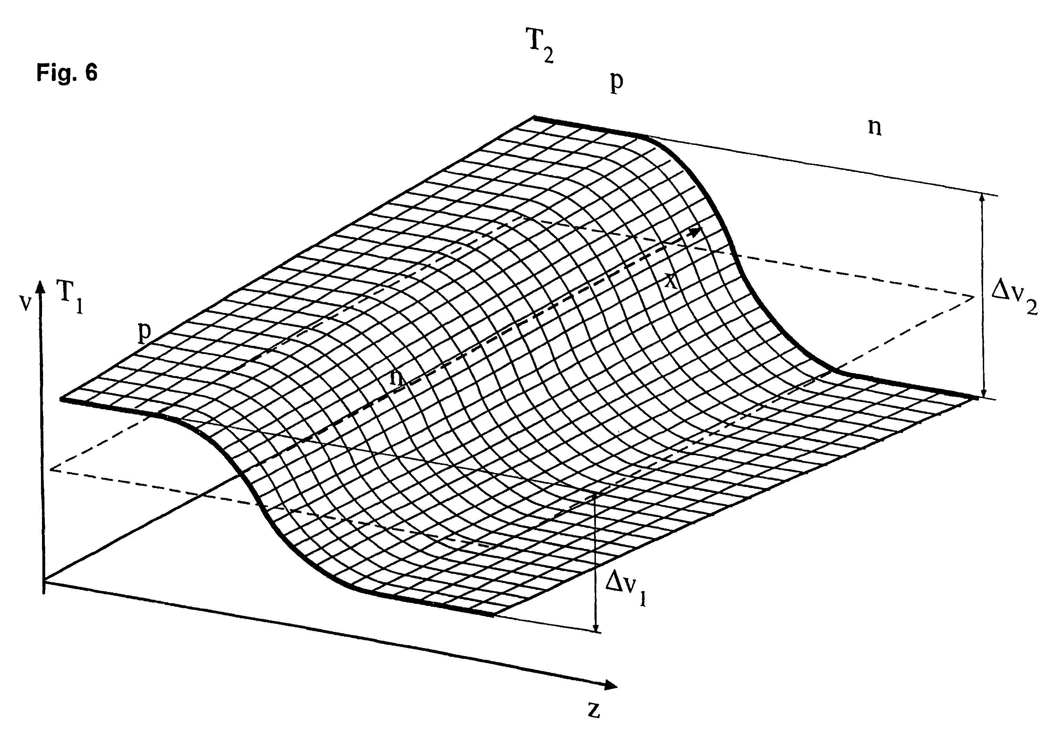

Ist nun in einem Schichtpaket aus mindestens einer n- und p-Schicht ein Temperaturgradient (T₁ > T₂) erfindungsgemäß parallel zur Grenzschicht zwischen n- und p-Schicht in x-Richtung, so sind Bereiche mit verschiedenen Temperaturen elektrisch in Kontakt. Da die Potentialmodulation mit zunehmender Temperatur geringer wird, hat dies zur Folge, daß benachbarte Punkte entlang der x-Achse sich auf verschiedenen Potentialen befinden. Fig. 6 zeigt dies schematisch in einer 3D-Darstellung.

Solange kein Strom fließt, ist die Fermienergie E_{f} waagrecht in einem z-V-Diagramm (Fig. 4). Es bildet sich also je ein Potentialgradient in x-Richtung sowohl in der p- als auch in der n-Schicht. Die Potentialgradienten sind in den beiden Schichten entgegengesetzt, also werden die Ladungsträger in beiden Schichten (Elektronen in der n- und Löcher in der p-Schicht) in dieselbe Richtung getrieben. Dieser Ladungsträgertransport heißt ambipolare Diffusion. Die Fig. 7 ist eine seitliche Ansicht von Fig. 6, um dieses Verhalten zu verdeutlichen (Löcher sind mit + und Elektronen mit - gekennzeichnet).

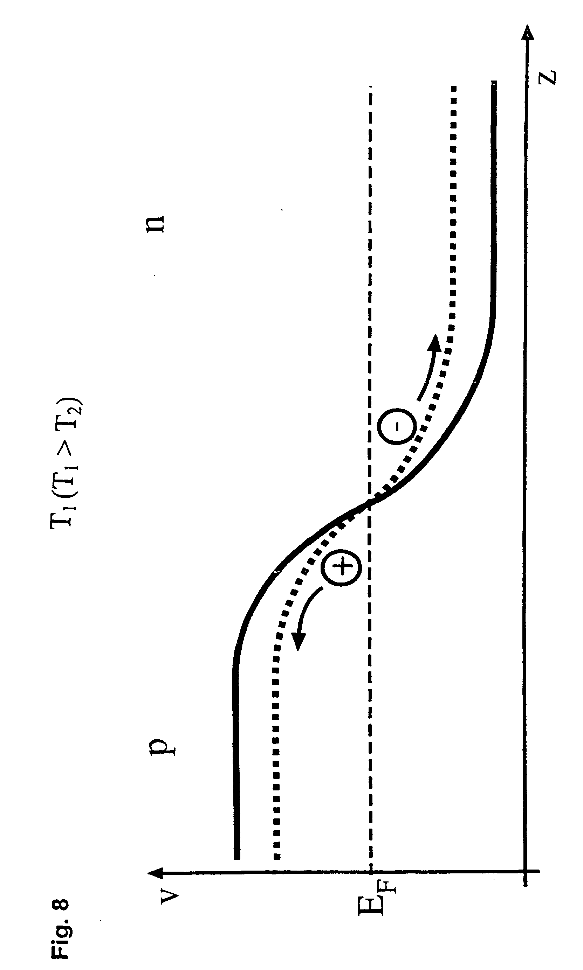

Die ambipolare Diffusion hat nun zur Folge, daß es im Bereich der hohen Temperatur T₁ des pn-Schichtpaketes zu einem Abtransport an Ladungsträgem und somit zu einem Ladungsträgerdefizit kommt, die Abschirmwirkung auf das Potential wird geringer und die Potentialmodulation steigt. Das hat zur Folge, daß der lokale pn-Übergang sich nicht mehr im thermischen Gleichgewicht befindet und die thermische Generation von Elektron-Loch-Paaren die Rekombination überwiegt (siehe Pfeile in Fig. 8).

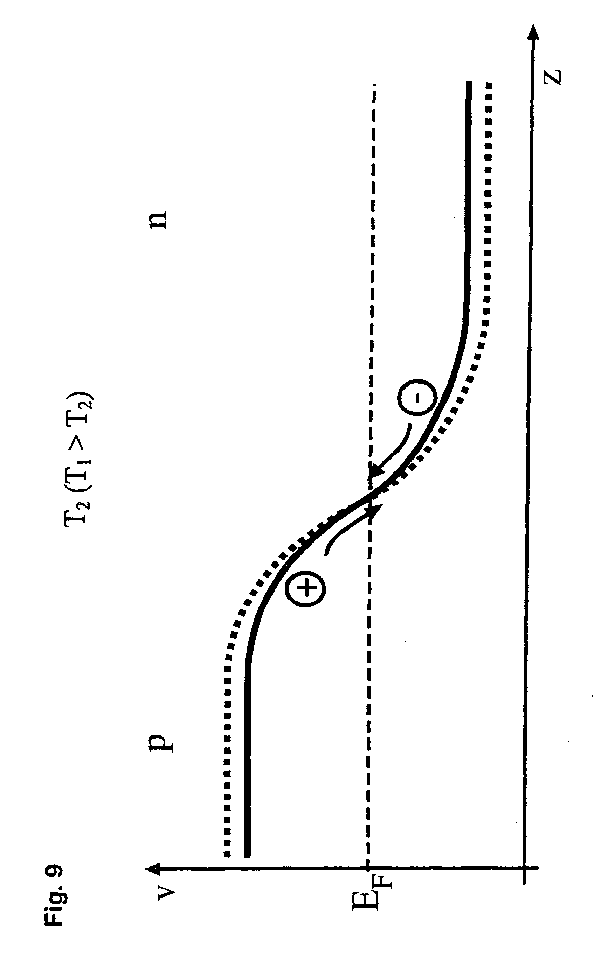

Im Bereich der niedrigen Temperatur T₂ kommt es zu einem Ladungsträgerüberschuß, der wiederum die Abschirmwirkung auf das lokale Potential erhöht und so zu einer Verringerung der lokalen Potentialmodulation im Vergleich mit dem thermischen Gleichgewicht führt. Das bewirkt nun eine verstärkte Rekombination der Elektron-Loch-Paare (siehe Pfeile Fig. 9).

In Summe ergibt sich nun, daß in einem Schichtpaket mit mindestens einem pn-Übergang ein Kreisstrom fließt, solange ein Bereich des Schichtpaketes wärmer als der Rest ist, d.h. es einen Temperaturgradienten parallel zur Grenzschicht gibt. Dieser Kreisstrom transportiert Wärme.

Durch den Temperaturgradienten parallel zur Grenzschicht zwischen n- und p-Schicht kommt es also zu einer Generation von Elektron-Loch-Paaren im Bereich der hohen Temperatur und zu einer Rekombination dieser Paare im Bereich der niedrigen Temperatur mit den dazugehörigen Ausgleichsströmen. Da sich die Potentialmodulation zwischen n- und p-Schicht im Vergleich zum thermischen Gleichgewicht ändert, kann eine Spannung zwischen n- und p-Schicht gemessen werden.

Da sich die Potentialmodulation zwischen n- und p-Schicht ändert und Generations- und Rekombinationsströme fließen, müssen Kontakte verwendet werden, die selektiv jeweils nur die n- Schicht kontaktieren und andere Kontakte verwendet werden, die selektiv jeweils nur die p-Schicht kontaktieren, um die Ströme nach außen abführen zu können. Die Selektivität kann entweder durch Legierungsbildung (Fig. 3a) und Bildung von pn-Übergängen oder durch direkte Kontaktierung (Fig. 3, Fig. 3b) der einzelnen Schichten sichergestellt werden.

Das Prinzip der pn-Übergänge ist allgemein gültig, daher können alle Materialien, die einen pn-Übergang bilden, für die Thermoelektrizität interessant werden.

Die für die Thermoelektrizität wichtigen Eigenschaften eines Materials (S ... Seebeck-Koeffizient, ρ ... spezifischer Widerstand, k ... Wärmeleitfähigkeit) lassen sich nur in sehr geringem Maße voneinander unabhängig beeinflussen. Bei dem hier vorgestellten neuen Prinzip haben die lateralen Änderungen der wichtigen physikalischen Parameter in x-Richtung einen Einfluß auf das gesamte Element, daher öffnet sich eine Fülle von neuen Möglichkeiten zur Erhöhung des Wirkungsgrades. Zu diesen physikalischen Parametern zählen die Zusammensetzung des verwendeten Materials, die Dotierungen, die Schichtdicken, die Breite, usw.

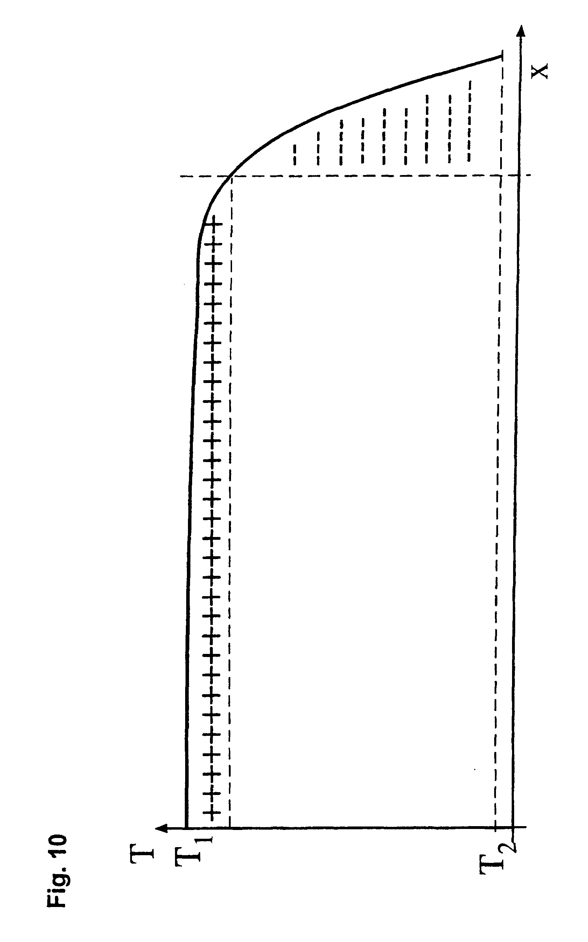

Die Art des Temperaturgradienten hat einen Einfluß auf den Wirkungsgrad, d.h. durch geschickte Wahl der Temperaturverteilung läßt sich der Wirkungsgrad steigern. Wenn, wie in Fig. 10 gezeigt, der Bereich der hohen Temperatur im Vergleich zum Bereich mit niedriger Temperatur sehr groß ist (flacher Gradient bei hohen Temperaturen, steiler Gradient bei niedrigen Temperaturen), dann ergibt sich ein größerer Bereich mit Generation von Elektron-Loch-Paaren (mit + gekennzeichnet) und ein kleiner Bereich mit erhöhter Rekombination (mit - gekennzeichnet), also eine Verstärkung der Kreisströme und der Wirkungsgrad des Gesamtsystems steigt.

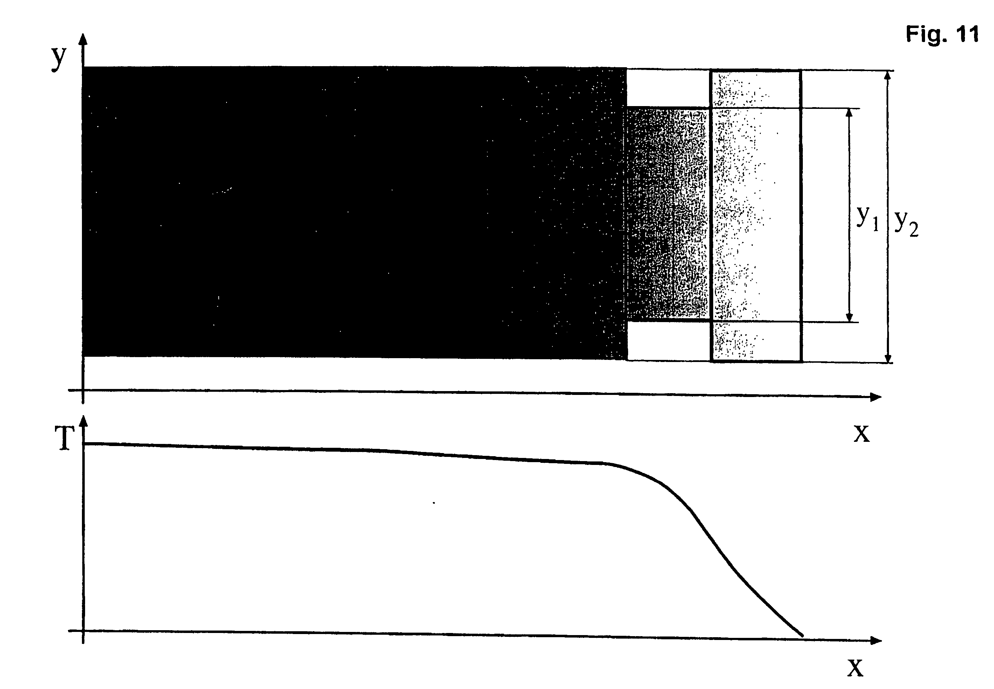

Ein solcher Gradient kann durch verschiedene Maßnahmen erreicht werden. Eine Möglichkeit ist eine Variation in der Zusammensetzung des Materials, sodaß am heißen Ende ein Material mit höherer Wärmeleitfähigkeit als am kalten Ende zum Einsatz kommt. Auch eine Breitenänderung kann den gewünschten Temperaturgradienten bewirken, wie es schematisch in Fig. 11 gezeigt ist.

Eine Stromentnahme am kalten Ende wirkt wie eine verstärkte Rekombination und die internen Potentialgradienten in x-Richtung werden erhöht, was die ambipolare Diffusion verstärkt. D.h. die ambipolare Diffusion der Ladungsträger wird durch eine Stromentnahme noch verstärkt, das bedeutet, durch Stromentnahme wird der Wirkungsgrad erhöht.

Für die Erfindung sind grundsätzlich dieselben physikalischen Parameter wie im konventionellen Konzept von Bedeutung. Allerdings können mit dem hier vorgestellten Konzept die Abhängigkeit der Parameter untereinander beeinflußt werden, da die laterale Änderung der Parameter einen Einfluß auf den Wirkungsgrad der Gesamtstruktur hat.

Zusätzlich eröffnet dieses Konzept eine Fülle von neuen Kandidaten für gute thermoelektrische Materialien.

Es gibt kaum eine Einschränkung in der Auswahl der Materialien, da alle elektrisch leitenden Stoffe einen thermoelektrischen (Seebeck-) Effekt zeigen. Allerdings unterscheiden sich die Materialien im Wirkungsgrad und auch im Wirkungsgrad als Funktion der Temperatur. Es müssen also die verwendeten Materialien aufgrund des gewünschten Temperaturbereiches ausgewählt werden.

Verbindungshalbleiter sind aufgrund der niedrigen Wärmeleitfähigkeit die bevorzugten Materialien für thermoelektrische Elemente. Einige Beispiele für gute thermoelektrische Materialien sind: Bi₂Te_{3,} PbTe, SiGe. Auch einige ternäre und quaternäre Verbindungen zeigen hohe Wirkungsgrade. Die aktuelle Forschung beschäftigt sich hauptsächlich mit der Suche nach diesen neuen Materialien.

Elementare Halbleiter (wie Si) weisen aufgrund der zu guten Wärmeleitfähigkeit einen schlechten Wirkungsgrad in der konventionellen Bauweise auf und werden daher nicht als thermoelektrische Materialien verwendet.

Mit der hier vorgestellten Idee können aber auch diese Materialien einen hohen Wirkungsgrad erzielen, da die Temperaturverteilung zusätzlich zum Verhältnis von elektrischer und thermischer Leitfähigkeit eine Rolle spielt.

Es sind hohe bis sehr hohe Dotierungen notwendig, um den spezifischen Widerstand möglichst gering zu halten. Die Werte für die Dotierungen sind natürlich abhängig vom Material. Als Beispiel: bei PbTe sind Dotierungen von 10¹⁸cm⁻³ und höher notwendig.

Die Art der Kontaktierung ist von größter Wichtigkeit für das neue Konzept. Da die internen Ausgleichsströme abgezweigt werden sollen, müssen die Schichten selektiv kontaktiert werden. Diese selektive Kontaktierung kann entweder durch eine direkte und ausschließliche elektrische Verbindung zur gewünschten Schicht oder durch Einlegieren der Kontakte geschehen.

Es ist nicht nur die absolute Temperaturdifferenz wichtig, sondern auch der Temperaturgradient spielt eine große Rolle. Durch eine geschickte Wahl der Temperaturverteilung mit einem flachen Gradienten im Bereich der hohen Temperaturen und einem steilen Gradienten hin zum Ende mit der niedrigen Temperatur läßt sich der Wirkungsgrad erhöhen.

Der sich intern aufbauende Potentialgradient kann z.B. durch eine Änderung der Potentialmodulation zwischen n- und p-Schicht aufgrund eines Dotiergradienten erhöht werden. Auch die Wärmeleitfähigkeit kann lateral (x-Richtung) durch Dickenänderungen oder Variationen der Zusammensetzung beeinflußt und damit der gewünschte Temperaturgradient erreicht werden.

Der interne Potentialgradient wird durch die Entnahme von Ladungsträgern noch verstärkt. Somit ergibt sich eine positive Rückkopplung und der Wirkungsgrad der Energieumwandlung wird erhöht.

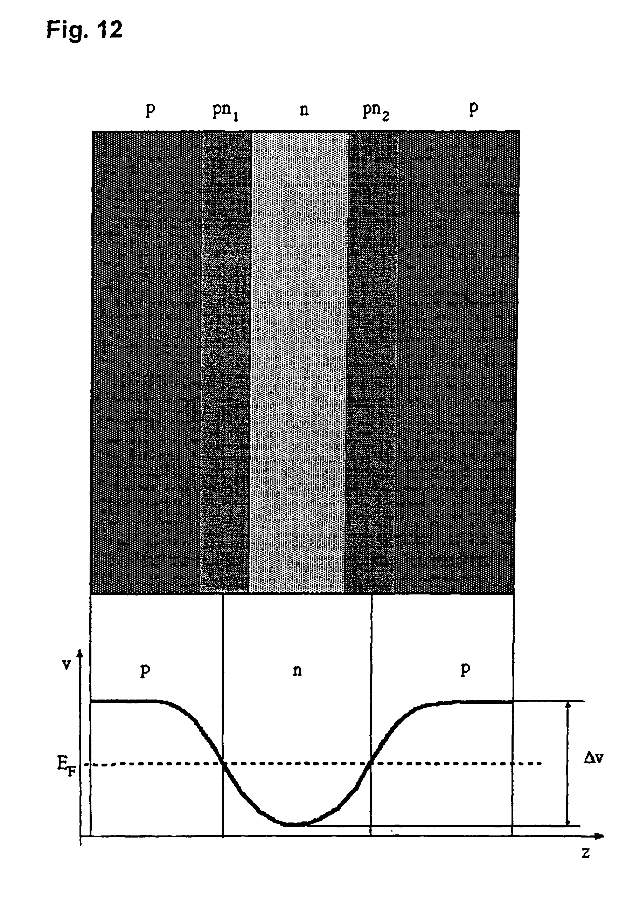

Es muß mindestens ein pn-Übergang vorhanden sein. Es können aber auch mehr als ein Übergang verwendet werden, wobei sich n- und p-Schichten immer abwechseln müssen. Fig. 12 zeigt ein Ausführungsbeispiel mit Schichtfolge p-n-p und zwei pn-Übergängen pn₁ und pn₂.

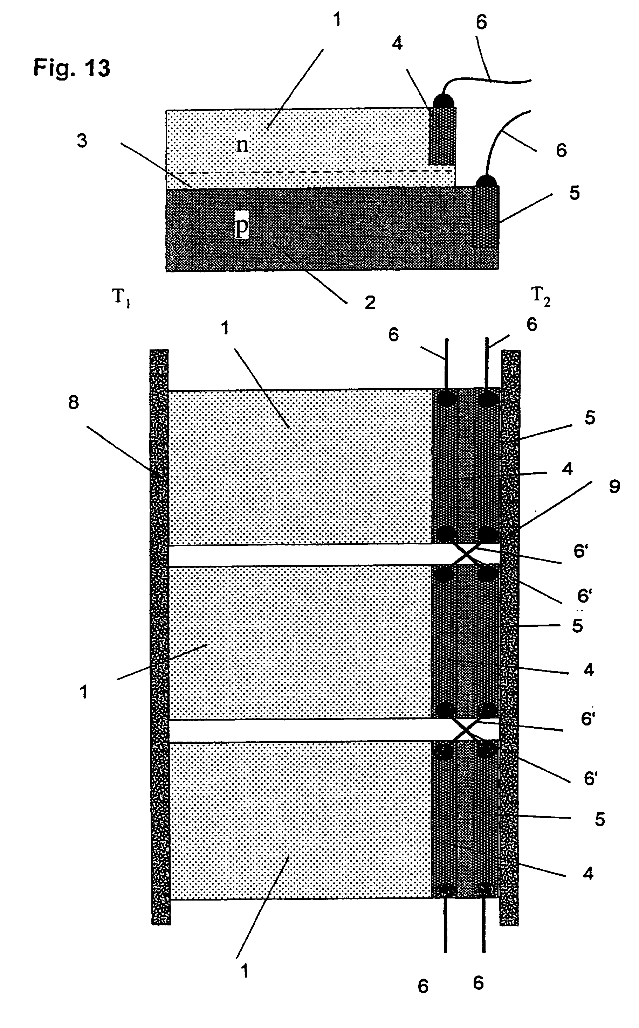

Die hier vorgestellten erfindungsgemäßen Elemente können zu Modulen zusammengefaßt werden, um eine elektrische Serien- und eine thermische Parallelschaltung zu erreichen. Eine mögliche Bauweise eines solchen Moduls ist in Fig. 13 gezeigt.

Bei dem in Fig. 13 dargestellten Ausführungsbeispiel sind drei thermoelektrische Einzelelemente mit einer Schichtfolge wie in Fig. 13 oben zwischen zwei Platten 8 und 9 thermisch parallel angeordnet. Elektrisch sind die Einzelelemente in Serie geschaltet, und zwar durch über Kreuz geführte Leitungen 6'. Die Platten 8 und 9 dienen der verbesserten thermischen Ankopplung und können optional auch weggelassen werden. Sie sind vorzugsweise als gute Wärmeleiter ausgebildet und zur Verhinderung von elektrischen Kurzschlüssen vorzugsweise aus keramischen, elektrisch nicht leitenden Werkstoffen (z.B. Al₂O₃) aufgebaut.

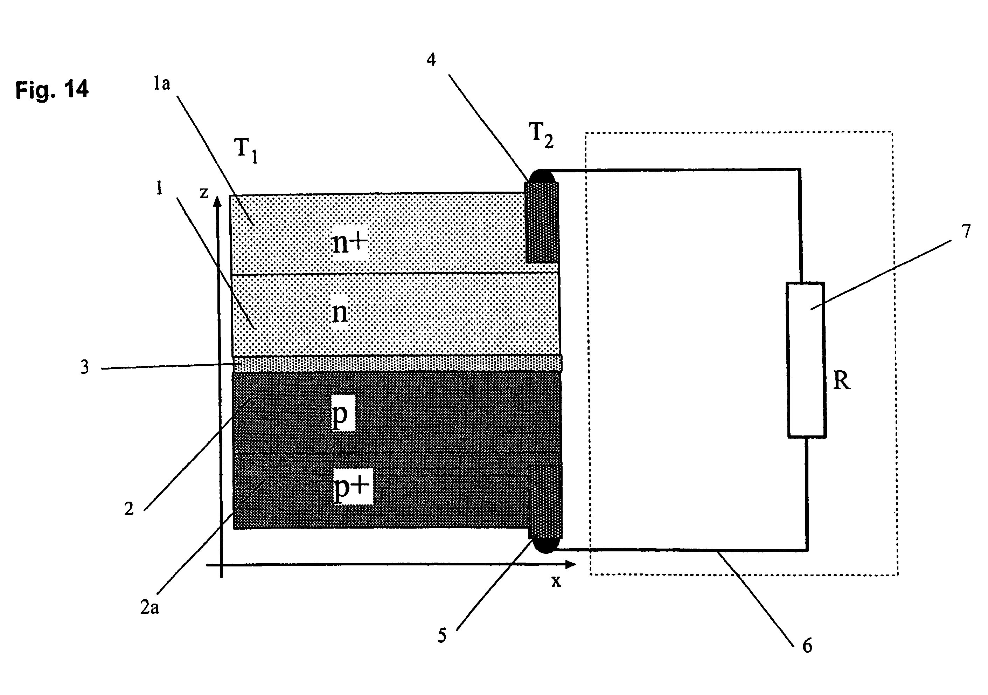

Um den Wirkungsgrad des thermoelektrischen Elementes bestehend aus zwei Schichten 1,2 (n- und p-dotiert) und des sich dazwischen ausbildenden pn-Überganges zu verbessern, ist es, wie in Fig. 14 dargestellt, möglich, zwei weitere Schichten 1a, 2a hinzuzufügen. Zur vorhandenen n-Schicht 1 wird eine hochdotierte n-Schicht 1a und zur p-Schicht 2 wird eine hochdotierte p-Schicht 2a so hinzugefügt, daß die folgende Schichtstruktur mit 4 Schichten erhalten wird: n⁺ - n - p - p⁺.

Die selektive Kontaktierung bleibt identisch wie bei zwei Schichten.

Es sind vor allem drei Bereiche, in denen die Erfindung zur Anwendung gelangen kann:
1. Thermoelektrische Generatoren zur direkten Umwandlung einer Temperaturdifferenz in Strom. Mit diesem Konzept kann eine eventuell anfallende Restwärme, die ansonsten ungenutzt bliebe, genutzt werden.
2. Der zur Generation umgekehrte Effekt: Durch einen Stromfluß wird ein Ende heißt und das andere kalt. Dieser Effekt kann zur aktiven Kühlung (für die Erzielung von niedrigen Temperaturen oder zur Abführung von Wärme) verwendet werden.
3. Verstärkte Wärmeleitfähigkeit, die zu einer effizienten passiven Kühlung z.B. in Klimaanlagen oder für die (Leistungs-)Elektronik dienen kann.

## Patentansprüche

1. Thermoelektrisches Element mit mindestens einer n-Schicht und mindestens einer p-Schicht eines oder mehrerer dotierter Halbleiter, wobei die n-Schicht(en) und die p-Schicht(en) unter Ausbildung wenigstens eines pn-Überganges angeordnet sind, wobei zumindest eine n-Schicht und zumindest eine p-Schicht elektrisch selektiv kontaktiert sind und ein Temperaturgradient parallel (x-Richtung) zur Grenzschicht zwischen wenigstens einer n- und p-Schicht angelegt oder abgegriffen wird, **dadurch gekennzeichnet, daß** mindestens ein pn-Übergang im wesentlichen entlang der gesamten vorzugsweise längsten Ausdehnung der n-Schicht(en) (1) und der p-Schicht(en) (2) und damit im wesentlichen entlang deren gesamter Grenzschicht (3) ausgebildet ist.

2. Thermoelektrisches Element nach Anspruch 1, **dadurch gekennzeichnet, daß** zur selektiven Kontaktierung von n- und p-Schicht (1, 2) die Kontakte zumindest teilweise als direkte Kontaktierung (4, 5) der einzelnen Schichten ausgebildet sind.

3. Thermoelektrisches Element nach Anspruch 1, **dadurch gekennzeichnet, daß** zur selektiven Kontaktierung von n- und p-Schicht (1, 2) die Kontakte zumindest teilweise einlegiert sind.

4. Thermoelektrisches Element nach einem der Ansprüche 1 bis 3, **dadurch gekennzeichnet, daß** zumindest ein physikalischer Parameter des thermoelektrischen Elementes, vorzugsweise dessen Materialzusammensetzung, dessen Dotierung, dessen Schichtdicken und/oder dessen Breite, in einer Richtung parallel zur Grenzschicht (3), vorzugsweise in Richtung (x-Richtung) des Temperaturgradienten (T₁, T₂) variiert.

5. Thermoelektrisches Element nach einem der Ansprüche 1 bis 4, **dadurch gekennzeichnet, daß** der angelegte Temperaturgradient (T₁, T₂) beim heißen Ende flacher verläuft als beim kalten Ende (Fig. 10).

6. Thermoelektrisches Element nach Anspruch 5, **dadurch gekennzeichnet, daß** beim heißen Ende ein Material mit höherer Wärmeleitfähigkeit als am kalten Ende verwendet wird.

7. Thermoelektrisches Element nach Anspruch 5, **dadurch gekennzeichnet, daß** sich die quer zur Temperaturgradientenrichtung und parallel zur Grenzschicht gemessene Breite (y) des thermoelektrischen Elementes zum kalten Ende hin, vorzugsweise knapp vor diesem, sprunghaft verringert (Fig. 11).

8. Thermoelektrisches Element nach einem der Ansprüche 1 bis 7, **dadurch gekennzeichnet, daß** die selektive Kontaktierung (4, 4'; 5) zur Stromabnahme im Bereich des kalten Endes des thermoelektrischen Elementes erfolgt.

9. Thermoelektrisches Element nach einem der Ansprüche 1 bis 8, **dadurch gekennzeichnet, daß** als Materialien Verbindungshalbleiter - vorzugsweise Bi₂Te₃, PbTe, SiGe - eingesetzt werden.

10. Thermoelektrisches Element nach einem der Ansprüche 1 bis 9, **dadurch gekennzeichnet, daß** als Materialien temäre und/oder quatemäre Verbindungen eingesetzt werden.

11. Thermoelektrisches Element nach einem der Ansprüche 1 bis 10, **dadurch gekennzeichnet, daß** hohe Dotierungen von 10¹⁸ cm⁻³ und höher zum Einsatz kommen.

12. Thermoelektrisches Element nach einem der Ansprüche 1 bis 11, **dadurch gekennzeichnet, daß** zwei oder mehrere pn-Übergänge vorgesehen sind, wobei sich n- und p-Schicht in der Abfolge abwechseln (Fig. 12).

13. Thermoelektrisches Element nach einem der Ansprüche 1 bis 12, **dadurch gekennzeichnet, daß** es aus zwei oder mehreren thermisch parallel und elektrisch in Serie geschalteten Einzelelementen aufgebaut ist (Fig. 13).

14. Thermoelektrisches Element nach Anspruch 13, **dadurch gekennzeichnet, daß** die Einzelelemente am kalten und am heißen Ende jeweils über einen guten, vorzugsweise keramischen, Wärmeleiter (8, 9) thermisch in Verbindung stehen und vorzugsweise daran befestigt sind.

15. Verwendung eines thermoelektrischen Elements nach einem der Ansprüche 1 bis 14 als thermoelektrischer Generator zur Umwandlung einer Temperaturdifferenz in Strom.

16. Verwendung eines thermoelektrischen Elements nach einem der Ansprüche 1 bis 15 als Kühlelement, wobei durch einen angelegten Stromfluß das eine Ende heiß und das andere Ende kalt wird.

## Claims

1. Thermoelectric element with at least one n-layer and at least one p-layer of one or more doped semiconductors, wherein the n-layer(s) and the p-layer(s) are disposed so that at least one pn-junction is formed, wherein at least one n-layer and at least one p-layer are electrically selectively contacted and a temperature gradient is established or obtained parallel (x-direction) to the boundary layer between at least one n- and p-layer, **characterized in that** at least one pn-junction is essentially formed along the total, preferably longest extent of the n-layer(s) (1) and p-layer(s) (2) and thus essentially along their whole boundary layer (3).

2. Thermoelectric element according to claim 1, **characterized in that** for the selective contacting of n- and p-layer (1, 2), the contacts are formed at least partially as direct contacting (4, 5) of the individual layers.

3. Thermoelectric element according to claim 1, **characterized in that** for the selective contacting of n- and p-layer (1, 2), the contacts are at least partially alloyed.

4. Thermoelectric element according to one of claims 1 to 3, **characterized in that** at least one physical parameter of the thermoelectric element, preferably its material composition, its doping, layer thicknesses and/or width, varies in a direction parallel to the boundary layer (3), preferably in the direction (x-direction) of the temperature gradient (T₁, T₂).

5. Thermoelectric element according to one of claims 1 to 4, **characterized in that** the established temperature gradient (T₁, T₂) is flatter at the hot end than at the cold end (Fig. 10).

6. Thermoelectric element according to claim 5, **characterized in that**, at the hot end, a material with higher heat conductivity is used than at the cold end.

7. Thermoelectric element according to claim 5, **characterized in that** the width (y) of the thermoelectric element measured across the temperature gradient direction and parallel to the boundary layer, decreases sharply towards the cold end, preferably just before it (Fig. 11).

8. Thermoelectric element according to one of claims 1 to 7, **characterized in that** the selective contacting (4, 4'; 5) for current supply is made in the region of the cold end of the thermoelectric element.

9. Thermoelectric element according to one of claims 1 to 8, **characterized in that** compound semiconductors - preferably Bi₂Te₃, PbTe, SiGe - are used as materials.

10. Thermoelectric element according to one of claims 1 to 9, **characterized in that** ternary and/or quaternary compounds are used as materials.

11. Thermoelectric element according to one of claims 1 to 10, **characterized in that** high doping values of 10¹⁸ cm⁻³ and higher are used.

12. Thermoelectric element according to one of claims 1 to 11, **characterized in that** two or more pn-junctions are provided, with n- and p-layers alternating in the sequence (Fig. 12).

13. Thermoelectric element according to one of claims 1 to 12, **characterized in that** it is made up of two or more thermally parallel and electrically series-connected individual elements (Fig. 13).

14. Thermoelectric element according to claim 13, **characterized in that** the individual elements at the cold end and at the hot end are in each case thermally connected via a good, preferably ceramic, heat conductor (8,9) and are preferably attached to this.

15. Use of a thermoelectric element according to one of claims 1 to 14 as a thermoelectric generator to convert a temperature difference into current.

16. Use of a thermoelectric element according to one of claims 1 to 14 as a cooling element, wherein one end becomes hot and the other end becomes cold due to an established flow of current.

## Revendications

1. Elément thermoélectrique comportant au moins une couche n et au moins une couche p d'un ou de plusieurs semi-conducteurs dopés, la (les) couche(s) n et la (les) couche(s) p étant disposées en formant au moins une jonction pn, au moins une couche n et au moins une couche p étant en contact électrique sélectif et un gradient de température étant appliqué ou prélevé parallèlement (direction x) à la couche limite entre au moins une couche n et une couche p, **caractérisé en ce qu'**au moins une jonction pn est conçue à peu près le long de l'ensemble de l'extension, de préférence la plus longue, de la/des couche(s) n (1) et de la /des couche(s) p (2) et donc sensiblement le long de leur couche limite globale (3).

2. Elément thermoélectrique selon la revendication 1, **caractérisé en ce que**, pour l'établissement du contact sélectif de la couche n et de la couche p (1, 2), les contacts sont réalisés au moins partiellement comme un contact direct (4, 5) des couches individuelles.

3. Elément thermoélectrique selon la revendication 1, **caractérisé en ce que**, pour l'établissement du contact sélectif de couches (1, 2) n et p, les contacts sont au moins partiellement alliés.

4. Elément thermoélectrique selon l'une quelconque des revendications 1 à 3, **caractérisé en ce qu'**au moins un paramètre physique de l'élément thermoélectrique, de préférence sa composition de matériau, son dopage, ses épaisseurs de couche et/ou sa largeur, varient dans une direction parallèlement à la couche limite (3), de préférence dans la direction (direction de x) du gradient de température (T₁, T₂).

5. Elément thermoélectrique selon l'une quelconque des revendications 1 à 4, **caractérisé en ce que** le gradient de température (T₁, T₂) appliqué varie plus platement sur l'extrémité chaude que sur l'extrémité froide (figure 10).

6. Elément thermoélectrique selon la revendication 5, **caractérisé en ce qu'**on utilise sur l'extrémité chaude un matériau avec une conductibilité thermique plus élevée que sur l'extrémité froide.

7. Elément thermoélectrique selon la revendication 5, **caractérisé en ce que** la largeur (y), mesurée transversalement au sens du gradient de température et parallèlement à la couche limite, de l'élément thermoélectrique se réduit brusquement en direction de l'extrémité froide, de préférence juste avant celle-ci (figure 11).

8. Elément thermoélectrique selon l'une quelconque des revendications 1 à 7, **caractérisé en ce que** l'établissement du contact sélectif (4, 4', 5) pour le prélèvement de courant s'effectue dans la zone de l'extrémité froide de l'élément thermoélectrique.

9. Elément thermoélectrique selon l'une quelconque des revendications 1 à 8, **caractérisé en ce qu'**on utilise comme matériaux des jonctions de semiconducteur de liaison, de préférence Bi₂Te₃, PbTe, SiGe.

10. Elément thermoélectrique selon l'une quelconque des revendications 1 à 9, **caractérisé en ce qu'**on utilise comme matériaux des jonctions ternaires et/ou quaternaires.

11. Elément thermoélectrique selon l'une quelconque des revendications 1 à 10, **caractérisé en ce qu'**on utilise des dopages élevés de 10¹⁸ cm⁻³ et plus.

12. Elément thermoélectrique selon l'une quelconque des revendications 1 à 11, **caractérisé en ce qu'**il est prévu deux ou plusieurs jonctions pn, la couche n et la couche p alternant dans la séquence (12).

13. Elément thermoélectrique selon l'une quelconque des revendications 1 à 12, **caractérisé en ce qu'**il est conçu à base de deux ou plusieurs éléments individuels montés en parallèle au plan thermique et en série au plan électrique (figure 13).

14. Elément thermoélectrique selon la revendication 13, **caractérisé en ce que** les éléments individuels sont en liaison thermique sur l'extrémité froide et sur l'extrémité chaude respectivement au moyen d'un bon conducteur thermique (8, 9), de préférence céramique, et sont fixés de préférence dessus.

15. Utilisation d'un élément thermoélectrique selon l'une quelconque des revendications 1 à 14 comme générateur thermoélectrique pour la transformation d'une différence de température en courant.

16. Utilisation d'un élément thermoélectrique selon l'une quelconque des revendications 1 à 5 comme élément de réfrigération, une extrémité devenant chaude et l'autre froide grâce à un flux de courant appliqué.
